# EUROPÄISCHE PATENTANMELDUNG

(11) **EP 2 660 739 A1**
(43) Veröffentlichungstag der Anmeldung: **06.11.2013**
(21) Anmeldenummer: 12166383.5
(22) Anmeldetag: 02.05.2012
(51) Int. Cl.: G06F 17/50

(54) **Verfahren und Vorrichtung zum Erstellen eines Anlagenlayouts eines Photovoltaik-Freiflächenkraftwerks**

(71) Anmelder: Siemens Aktiengesellschaft, 80333 München (DE)
(72) Erfinder: Fink, Rafael, 81829 München (DE)

(57) **Zusammenfassung**

Die Erfindung betrifft ein Verfahren und eine Vorrichtung zum Erstellen eines Anlagenlayouts eines Photovoltaik-Freiflächenkraftwerks, welches Kraftwerkskomponenten, insbesondere Solartracker aufweist, mit folgenden Verfahrensschritten: Bereitstellen von Konfigurationsdaten, welche das Photovoltaik-Freiflächenkraftwerk und dessen Kraftwerkskomponenten spezifizieren, und von Konfigurationsregeln, welche für das Photovoltaik-Freiflächenkraftwerk vorgegeben werden, sowie von Konfigurationsparametern, welche die Konfigurationsregeln konkretisieren; und Initialisieren und anschließendes Optimieren einer Auswahl und einer Verortung von benötigten Kraftwerkskomponenten für die Anlagenlayouteigenschaften des Photovoltaik-Freiflächenkraftwerks anhand der bereitgestellten Konfigurationsdaten und der konkretisierten Konfigurationsregeln zur Erstellung des Anlagenlayouts des Photovoltaik-Freiflächenkraftwerks.

## Beschreibung

### Technisches Gebiet

Die Erfindung betrifft ein Verfahren und eine Vorrichtung zum Erstellen eines Anlagenlayouts eines Photovoltaik-Freiflächenkraftwerks, das Kraftwerkskomponenten, insbesondere Solartracker, aufweist.

### Stand der Technik

Die standortbezogene Projektierung und Einrichtung von Photovoltaik-Freiflächenkraftwerken stellt bei herkömmlichen Entwicklungsverfahren einen Engpass dar. Das Layout von Photovoltaik-Anlagen wird bei herkömmlichen Entwicklungsverfahren für jede Anlage individuell mit Hilfe einer Tabellenkalkulations-basierten, von Experten manuell durchgeführten Planung entworfen oder vollumfänglich von einem Planer erstellt.

Diese herkömmlichen Verfahren sind sehr zeitintensiv und wegen der enormen Datenmenge auch fehleranfällig. Aufgrund der sich von Anlage zu Anlage stets ändernden Voraussetzungen, wie beispielsweise der Umriss des zu beplanenden Geländes, regionale Reglementierungen oder ähnliches, ist es nicht möglich, bereits entworfene Photovoltaik-Freiflächenkraftwerke bei der Planung anderer Anlagen wiederzuverwenden oder anzupassen, so dass für jede Anlage eine umfassende, eigenständige Planung durchzuführen ist.

In der für eine Angebotserstellung erforderlichen Grobplanung von Anlagen bleiben wegen der häufig knappen Ausschreibungsdauer im Allgemeinen wichtige Aspekte, die dann erst bei der Detailplanung behandelt werden, unberücksichtigt. Dies bedeutet im Hinblick auf die in dem Angebot gemachten Zusagen natürlich einen großen Unsicherheitsfaktor.

Eine Software-technische Unterstützung haben die Planer bisher lediglich bei der Wahl gewisser Konfigurationsparameter erhalten. Beispielswiese sind Software-Tools bekannt, mit deren Hilfe die Abhängigkeit der Leistung eines Photovoltaik-Freiflächenkraftwerks von Sonneneinstrahlungsdaten und von der Lage des zu beplanenden Geländes des Photovoltaik-Freiflächenkraftwerks ermittelt werden kann.

Die DE 33 01 046 C1 beschreibt Nachführungseinrichtungen, die es ermöglichen, Geräte einer bogenförmigen Bahn entsprechend auszurichten. Die dort beschriebenen Nachführungseinrichtungen eignen sich beispielsweise für Solareinrichtungen, wie photovoltaische Generatoren, Solarkocher und Heliostaten. Die nachzuführenden Geräte werden dabei im Normalfall um eine vertikale Achse drehbar angeordnet, wobei das erforderliche Kippen um eine horizontale Achse durch mindestens ein Führungsglied zwangsläufig mit der Drehung um die vertikale Achse erreicht wird. Das Führungsglied der dort beschriebenen Nachführungseinrichtungen verbindet den nachgeführten Teil mit einem festen Auflagepunkt.

Die DE 203 14 665 U1 beschreibt eine Anordnung zur flächigen Abdeckung von Geländeerhebungen, wie Schüttgut- oder Abraumhalden, Schallschutzwälle oder Hochwasserdämme oder sonstiger Freiflächen mit einer zumindest teilweise geneigten und/oder gekrümmten Oberfläche, wobei eine Tragkonstruktion zur Aufnahme von Abdeckelementen vorgesehen ist, die mit wenigstens einem Abdeckelement bestückt ist, welche in einem Abstand zur Oberfläche der Geländeerhebung angeordnet sind und die Oberfläche der Geländeerhebung zumindest teilweise überdecken.

Es ist daher eine Aufgabe der vorliegenden Erfindung, ein Verfahren und eine Vorrichtung zu schaffen, welches nach Maßgabe von Konfigurationsregeln und Konfigurationsparametern eine Projektierung und eine Einrichtung eines Photovoltaik-Freiflächenkraftwerks mit Solartrackern auf der Basis von spezifizierten Konfigurations- und Geländedaten ermöglicht.

Diese Aufgabe wird erfindungsgemäß durch ein Verfahren mit den im Patentanspruch 1 angegebenen Merkmalen sowie durch eine Vorrichtung mit den Merkmalen gemäß Patentanspruch 13 gelöst.

Die Erfindung schafft demnach ein Verfahren zum Erstellen eines Anlagenlayouts eines Photovoltaik-Freiflächenkraftwerks, welches Kraftwerkskomponenten, insbesondere Solartracker, aufweist, mit folgenden Verfahrensschritten:
Als ein erster Verfahrensschritt erfolgt ein Bereitstellen von Konfigurationsdaten, welche das Photovoltaik-Freiflächenkraftwerk und dessen Kraftwerkskomponenten spezifizieren, und von Konfigurationsregeln, welche für das Photovoltaik-Freiflächenkraftwerk vorgegeben werden, sowie von Konfigurationsparametern, welche die Konfigurationsregeln konkretisieren.

In einem zweiten Verfahrensschritt erfolgt ein Initialisieren und ein anschließendes Optimieren einer Auswahl und einer Verortung von benötigten Kraftwerkskomponenten für Anlagenlayouteigenschaften des Photovoltaik-Freiflächenkraftwerks anhand der bereitgestellten Konfigurationsdaten und der konkretisierten Konfigurationsregeln zur Erstellung des Anlagenlayouts des Photovoltaik-Freiflächenkraftwerks.

Die vorliegende Erfindung schafft gemäß einem weiteren Aspekt eine Vorrichtung zum Erstellen eines Anlagenlayouts eines Photovoltaik-Freiflächenkraftwerks, welches Kraftwerkskomponenten, insbesondere Solartracker, aufweist, wobei die Vorrichtung ein Optimierungsmodul aufweist.

Die Vorrichtung ist dazu ausgelegt, das Photovoltaik-Freiflächenkraftwerk und Kraftwerkskomponenten spezifizierende Konfigurationsdaten, für das Photovoltaik-Freiflächenkraftwerk vorgegebene Konfigurationsregeln und die Konfigurationsregeln konkretisierende Konfigurationsparameter bereitzustellen.

Ferner ist die Vorrichtung dazu ausgelegt, eine Auswahl und eine Verortung von benötigten Kraftwerkskomponenten für Anlagenlayouteigenschaften des Photovoltaik-Freiflächenkraftwerks anhand der bereitgestellten Konfigurationsdaten und der konkretisierten Konfigurationsregeln zu initialisieren und anschließend zu optimieren, um das Anlagenlayout des Photovoltaik-Freiflächenkraftwerks zu erstellen.

Eine der Erfindung zugrundeliegende Idee liegt darin, eine Planungssoftware bereitzustellen, die eine automatische Anlagenlayoutberechnung unter anderem bei der Optimierung der Verschaltung von Kraftwerkskomponenten und bei der Optimierung des Layouts von Photovoltaik-Freiflächenkraftwerken mit Solartrackern ermöglicht.

Dabei werden die für die Layout-Planung einer Anlage entscheidenden Faktoren optimiert, das heißt insbesondere die Platzierung der Kraftwerkskomponenten unter Ausnutzung der für das Photovoltaik-Freiflächenkraftwerk zur Verfügung stehenden Fläche.

Die technische Herausforderung liegt dabei zum einen in der korrekten Modellierung der Teilprobleme einer zu lösenden Aufgabe und zum anderen in der Geschwindigkeit, mit der solche Lösungen automatisiert auf einem Computer berechnet werden können.

Eine kurze Berechnungsdauer ist dabei ein wesentlicher Faktor. Das erfindungsgemäße Verfahren berechnet auch für große Anlagen innerhalb weniger Minuten ein optimiertes Layout und ermöglicht, die Projektierungszeit im Vergleich zur bisher durchgeführten manuellen Planung signifikant zu reduzieren.

Durch eine graphische Benutzeroberfläche werden alle für die Anlagenplanung des Photovoltaik-Freiflächenkraftwerks erforderlichen Funktionalitäten benutzerfreundlich zur Verfügung gestellt, unter anderem die Dateneingabe, der Optimierungskern, die Visualisierung der Lösung und der Export der Ergebnisse zur Weiterverarbeitung in rechnerunterstützten Entwurf- oder Kostenkalkulations-Tools.

Das vollständige Optimierungsproblem des erfindungsgemäßen Verfahrens weist eine hohe Komplexität auf und wird daher durch einen hierarchischen Ansatz gelöst, das heißt eine Dekomposition der Aufgabenstellung in Teileinheiten. Selbst die durch die Dekomposition entstehenden Einzelprobleme sind teilweise schwierig zu lösen und erfordern das Bereitstellen spezialisierter und komplexer Berechnungsverfahren.

Die Aufgabenstellung des erfindungsgemäßen Verfahrens umfasst einen Optimierer, welcher als eine Mehrzahl von technischen Algorithmen ausgebildet ist, die zur Lösung des Gesamtproblems herangezogen werden.

Konfigurationsregeln sind zum einen physikalische Nebenbedingungen, die eingehalten werden müssen, und zum anderen Regeln, die im Hinblick auf eine Standardisierung der Anlagenlayouts oder zur Erleichterung des Anlagenaufbaus des Photovoltaik-Freiflächenkraftwerks und des Service von Experten festgelegt wurden.

Durch Festlegung von konkreten Werten für Konfigurationsparameter werden die Konfigurationsregeln konkretisiert. Die Konfigurationsdaten spezifizieren das zu planende Photovoltaik-Freiflächenkraftwerk und die Kraftwerkskomponenten des Photovoltaik-Freiflächenkraftwerks.

Als Konfiguration des Photovoltaik-Freiflächenkraftwerks ist ein Anlagenlayout zu erstellen, das heißt eine Platzierung der Solartracker mit den Photovoltaikmodulen, eine Verortung von Service- und Kabelwege zwischen den Solartrackern, eine Platzierung von Wechselrichtern und eine Zuordnung der Solartracker zu sogenannten Inverter-Gruppen.

Zur Berechnung des Anlagenlayouts des Photovoltaik-Freiflächenkraftwerks sind in Teilschritte hierarchisch unterteilte Anlagenlayout- und Verschaltungsprobleme der Konfiguration des Photovoltaik-Freiflächenkraftwerks für verschiedene Anlagenlayouteigenschaften des Photovoltaik-Freiflächenkraftwerks zu lösen.

Gemäß der Optimierungsaufgabe wird unter Berücksichtigung der Konfigurationsregeln in kurzer Zeit, das heißt innerhalb weniger Minuten, automatisiert ein geeignetes, optimiertes Anlagenlayout berechnet.

Zielsetzungen können dabei zum Beispiel eine möglichst gute Ausnutzung der zur Verfügung stehenden Fläche oder die Schaffung möglichst guter Voraussetzungen für eine einfache, effiziente und kostengünstige Verkabelung der Kraftwerkskomponenten des Photovoltaik-Freiflächenkraftwerks sein.

Die Optimierungsaufgabe liegt in der Berechnung eines hinsichtlich Nennleistung, Effizienz und Kosten optimierten Anlagenlayouts des Photovoltaik-Freiflächenkraftwerks unter Berücksichtigung der Konfigurationsregeln, in kurzer Zeit, das heißt innerhalb weniger Minuten.

Bei einer möglichen Ausführungsform des erfindungsgemäßen Verfahrens ist vorgesehen, dass zur Erstellung des Anlagenlayouts des Photovoltaik-Freiflächenkraftwerks ein Berechnen einer Wege-Konfiguration des Photovoltaik-Freiflächenkraftwerks zum Optimieren einer der Anlagenlayouteigenschaften vorgenommen wird. Dies erlaubt eine vorteilhafte Planung der Kabel- und Servicewege.

Bei einer möglichen Ausführungsform des erfindungsgemäßen Verfahrens ist vorgesehen, dass zur Erstellung des Anlagenlayouts des Photovoltaik-Freiflächenkraftwerks ein Berechnen einer Anzahl der Kraftwerkskomponenten des Photovoltaik-Freiflächenkraftwerks zum Optimieren einer der Anlagenlayouteigenschaften vorgenommen wird.

Bei einer möglichen Ausführungsform des erfindungsgemäßen Verfahrens ist vorgesehen, dass zur Erstellung des Anlagenlayouts des Photovoltaik-Freiflächenkraftwerks ein Berechnen einer Verortung der Solartracker des Photovoltaik-Freiflächenkraftwerks zum Optimieren einer der Anlagenlayouteigenschaften vorgenommen wird. Dadurch ergeben sich vorteilhafte Konfigurationen des Photovoltaik-Freiflächenkraftwerks mit verbesserten Lösungen der zu lösenden Anlagenlayout- und Verschaltungsprobleme des Photovoltaik-Freiflächenkraftwerks. Auf der Basis der berechneten Verortung können die Solartracker Inverter-Gruppen zugeordnet werden, die hinsichtlich ihrer Ausdehnung möglichst kompakt ausfallen.

Bei einer Ausführungsform des erfindungsgemäßen Verfahrens ist vorgesehen, dass zur Erstellung des Anlagenlayouts des Photovoltaik-Freiflächenkraftwerks ein Berechnen einer Zuordnung der Solartracker zu Inverter-Gruppen der Kraftwerkskomponenten des Photovoltaik-Freiflächenkraftwerks zum Optimieren einer der Anlagenlayouteigenschaften vorgenommen wird. Innerhalb der Inverter-Gruppen kann somit vorteilhaft eine Verkabelung der Kraftwerkskomponenten vorgesehen werden, die möglichst einfach, effizient und kostengünstig ist.

Bei einer Ausführungsform des erfindungsgemäßen Verfahrens ist vorgesehen, dass das Berechnen der Verortung der Solartracker des Photovoltaik-Freiflächenkraftwerks und das Berechnen der Zuordnung der Solartracker zu den Inverter-Gruppen im Zuge eines lokalen Verbesserungsverfahrens im Wechsel wiederholt vorgenommen wird. Dadurch können berechnete Layouts hinsichtlich ihrer Qualität in vorteilhafter Weise sukzessive verbessert werden.

Bei einer alternativen Ausführungsform des erfindungsgemäßen Verfahrens ist vorgesehen, dass eine Maximierung der Anzahl der Solartracker des Photovoltaik-Freiflächenkraftwerks zum Optimieren einer der Anlagenlayouteigenschaften vorgenommen wird. Dies ermöglicht, die Gesamtleistung des Photovoltaik-Freiflächenkraftwerks zu erhöhen.

Bei einer Ausführungsform des erfindungsgemäßen Verfahrens ist vorgesehen, dass die Erstellung des Anlagenlayouts des Photovoltaik-Freiflächenkraftwerks eine Prüfung der Kompatibilität der vorgesehenen Kraftwerkskomponenten zueinander umfasst. Dadurch kann die Betriebssicherheit des Photovoltaik-Freiflächenkraftwerks erhöht werden.

Bei einer möglichen Ausführungsform des erfindungsgemäßen Verfahrens ist vorgesehen, dass als die Konfigurationsdaten Daten zu einer Lage und einem Umriss eines das für das Photovoltaik-Freiflächenkraftwerk vorgesehenen Geländes bereitgestellt werden. Dies ermöglicht vorteilhaft eine optimale Anpassung des Photovoltaik-Freiflächenkraftwerks an die lokalen Gegebenheiten.

Bei einer möglichen Ausführungsform des erfindungsgemäßen Verfahrens ist vorgesehen, dass zur Erstellung des Anlagenlayouts des Photovoltaik-Freiflächenkraftwerks ein Optimierungsmodul mit mehreren Algorithmen verwendet wird, welches mehrere Berechnungsverfahren benutzt, die zur Projektierung und zur Einrichtung des Photovoltaik-Freiflächenkraftwerks verwendet werden, um verschiedene Anlagenlayouteigenschaften zu optimieren.

Bei einer möglichen Ausführungsform des erfindungsgemäßen Verfahrens ist vorgesehen, dass zur Durchführung des Verfahrens ein Benutzeroberflächenmodul verwendet wird, welches als graphische Benutzeroberfläche ausgelegt ist und/oder Funktionalitäten zur Dateneingabe und/oder zur Datenverwaltung und/oder zur Datenausgabe aufweist und/oder zum Aufruf des Optimierungsmoduls und/oder zur Ergebnisdarstellung ausgelegt ist. Dies ermöglicht eine sichere und einfache Datenkommunikation zwischen Anwender und Planungssoftware.

Bei einer möglichen Ausführungsform des erfindungsgemäßen Verfahrens ist vorgesehen, dass mindestens einer der Algorithmen des Optimierungsmoduls dazu ausgelegt wird, mit einer Zielfunktion eine Maximierung einer Anzahl der Solartrackern des Photovoltaik-Freiflächenkraftwerks zu erreichen.

Die beschriebenen Ausgestaltungen und Weiterbildungen lassen sich, sofern sinnvoll, beliebig miteinander kombinieren.

Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmalen der Erfindung.

### Zeichnungen

Die beiliegenden Zeichnungen sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung.

Andere Ausführungsformen und viele der genannten Vorteile ergeben sich im Hinblick auf die Zeichnungen. Die dargestellten Elemente der Zeichnungen sind nicht notwendigerweise maßstabsgetreu zueinander gezeigt.

Es zeigen:
- Fig. 1: eine Darstellung eines Ablaufdiagramms einer möglichen Ausführungsform des erfindungsgemäßen Verfahrens zum Erstellen eines Anlagenlayouts eines Photovoltaik-Freiflächenkraftwerks;
- Fig. 2: eine Darstellung einer Kartenansicht eines für ein Photovoltaik-Freiflächenkraftwerk zu beplanenden Geländes gemäß einer möglichen Ausführungsform der erfindungsgemäßen Vorrichtung;
- Fig. 3: eine Darstellung eines Solartrackers eines Photovoltaik-Freiflächenkraftwerks gemäß einer möglichen Ausführungsform der erfindungsgemäßen Vorrichtung;
- Fig. 4: eine Darstellung eines Solartrackers eines Photovoltaik-Freiflächenkraftwerks gemäß einer möglichen Ausführungsform der erfindungsgemäßen Vorrichtung;
- Fig. 5: eine Darstellung einer Inverter-Gruppe eines Photovoltaik-Freiflächenkraftwerks gemäß einer möglichen Ausführungsform der erfindungsgemäßen Vorrichtung;
- Fig. 6-7: jeweils eine Darstellung möglicher Anlagenlayouts, die gemäß einer möglichen Ausführungsform der erfindungsgemäßen Vorrichtung aus unterschiedlichen Vorgaben hinsichtlich der Anordnung der Solartracker in den Inverter-Gruppen resultieren;
- Fig. 8: eine Darstellung eines Ablaufdiagramms einer möglichen Ausführungsform des erfindungsgemäßen Verfahrens zum Erstellen einer Konfiguration eines Photovoltaik-Freiflächenkraftwerks mit Solartrackern, die in Standardblöcken angeordnet sind;
- Fig. 9: eine Darstellung eines Ablaufdiagramms einer möglichen Ausführungsform des erfindungsgemäßen Verfahrens zum Erstellen einer Konfiguration eines Photovoltaik-Freiflächenkraftwerks mit Solartrackern, die beliebig in Inverter-Gruppen zusammengefasst werden können;
- Fig. 10: eine Darstellung eines Detailausschnitts zur Platzierung der Solartracker bzw. Standardblöcke gemäß einer möglichen Ausführungsform des erfindungsgemäßen Verfahrens;
- Fig. 11-14: jeweils einen Detailausschnitt eines möglichen Anlagenlayouts einer Konfiguration eines Photovoltaik-Freiflächenkraftwerks gemäß einer möglichen Ausführungsform des erfindungsgemäßen Verfahrens; und
- Fig. 15: eine Darstellung eines Benutzeroberflächenmoduls zur Dateneingabe gemäß einer möglichen Ausführungsform des erfindungsgemäßen Verfahrens.

In den Figuren der Zeichnung bezeichnen gleiche Bezugszeichen gleiche oder funktionsgleiche Komponenten oder Verfahrensschritte, soweit nichts Gegenteiliges angegeben ist.

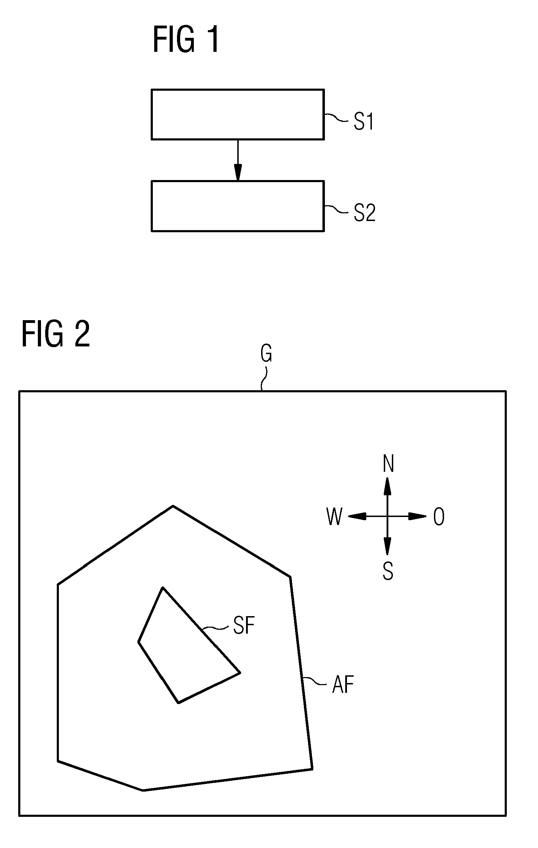

Die Figur 1 zeigt eine Darstellung eines Ablaufdiagramms einer möglichen Ausführungsform des erfindungsgemäßen Verfahrens zum Erstellen eines Anlagenlayouts eines Photovoltaik-Freiflächenkraftwerks.

In einem ersten Schritt des Verfahrens erfolgt ein Bereitstellen S1 von das Photovoltaik-Freiflächenkraftwerk PV und dessen Kraftwerkskomponenten spezifizierenden Konfigurationsdaten, von für das Photovoltaik-Freiflächenkraftwerk PV vorgegebenen Konfigurationsregeln und von die Konfigurationsregeln konkretisierenden Konfigurationsparametern.

Kraftwerkskomponenten sind beispielsweise Solartracker, Wechselrichter, Photovoltaikmodule, Solarzellenstrings, Solarzellentische, Kabel zur Verbindung, Kopplungskästen, Anschlusskästen oder Wechselrichter-Container oder sonstige elektrische Modulkomponenten.

In einem zweiten Verfahrensschritt werden durch eine Initialisierung und eine anschließende Optimierung S2 anhand der bereitgestellten Konfigurationsdaten und der konkretisierten Konfigurationsregeln zur Erstellung des Anlagenlayouts des Photovoltaik-Freiflächenkraftwerks PV für Anlagenlayouteigenschaften sowohl die Anzahl der benötigten Komponenten des Photovoltaik-Freiflächenkraftwerks PV als auch deren Positionierung festgelegt.

Die bereitgestellten Daten umfassen beispielsweise auch schaltungstechnische Nebenbedingungen oder sonstige Normbedingungen oder Sicherheitsrichtlinien des Photovoltaik-Freiflächenkraftwerks PV. Als schaltungstechnische Nebenbedingungen sind beispielsweise Platzierungsnebenbedingungen oder Nebenbedingungen zu elektrischen Größen von Kraftwerkskomponenten wie elektrische Maximal-Stromstärken oder elektrische Spannungen vorgesehen.

Beispielsweise können durch eine Festlegung von konkreten Werten für die Konfigurationsparameter die Konfigurationsregeln konkretisiert werden. Konfigurationsdaten spezifizieren beispielsweise die zu planende Anlage oder das Anlagenlayout des Photovoltaik-Freiflächenkraftwerks PV.

Beispielsweise konkretisiert ein Konfigurationsparameter von acht Solartrackern ST pro Inverter-Gruppe IG die Konfigurationsregeln bezüglich eines Zusammenschaltens der Solartracker ST zu einer Inverter-Gruppe IG.

Die Figur 2 zeigt eine Darstellung einer Kartenansicht eines für ein Photovoltaik-Freiflächenkraftwerk zu beplanendes Geländes gemäß einer möglichen Ausführungsform des erfindungsgemäßen Verfahrens.

In einem Gelände G, das durch seinen Umriss und eventuell eine oder mehrere vorhandene Sperrflächen SF definiert ist, wird ein Photovoltaik-Freiflächenkraftwerk PV auf einer Anlagenfläche AF geplant oder aufgestellt, wobei die Konfiguration des Photovoltaik-Freiflächenkraftwerks PV nach Nennleistung und/oder nach Kosten und/oder nach Effizienz optimiert wird.

Das zu beplanende Gelände G ist in der abgebildeten Ausrichtung dargestellt. Die West-Ost-Ausrichtung, W-O, ist durch die x-Koordinate gegeben, die Nord-Süd-Ausrichtung, N-S, durch die y-Koordinate.

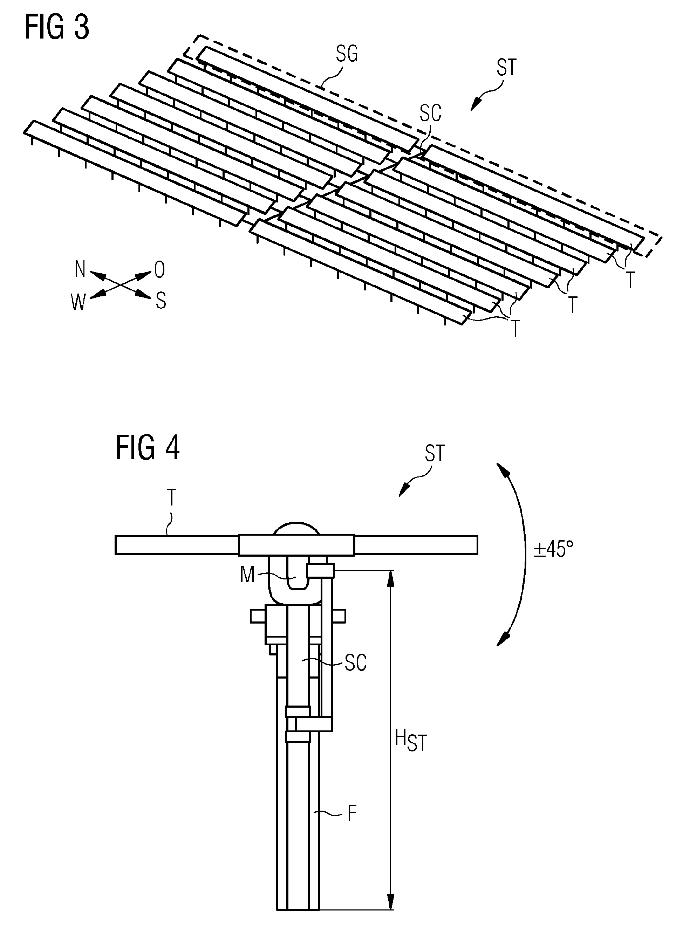

Die Figur 3 zeigt eine Darstellung eines Solartrackers eines Photovoltaik-Freiflächenkraftwerks gemäß einer möglichen Ausführungsform der erfindungsgemäßen Vorrichtung.

Mehrere gleichartige Photovoltaikmodule eines Photovoltaik-Freiflächenkraftwerks PV werden zu sogenannten Strings in Reihe geschaltet, die wiederum in Parallelschaltung an Eingänge von Wechselrichtern des Photovoltaik-Freiflächenkraftwerks PV angeschlossen werden. Welche Anzahl an Photovoltaikmodulen in einem String möglich ist, hängt von den Spezifikationsdaten der Wechselrichter ab.

Die Spezifikationsdaten der Wechselrichter werden als Daten zu den Kraftwerkskomponenten des Photovoltaik-Freiflächenkraftwerks PV bereitgestellt.

Auf einen Solartracker ST werden die zu Strings verschalteten Photovoltaikmodule auf einem Trackergestell montiert. Die Solartracker ST sind dem Sonnenstand nachgeführte Trägersysteme, bei denen beispielsweise das Trägersystem, die montierten Photovoltaikmodule, die Steuerung oder ähnliche Komponenten integriert aufeinander abgestimmt sind.

Ein Trackergestell des Solartrackers ST umfasst mehrere parallele, in Nord-Süd-Richtung verlaufende Segmente SG. Dabei sind alle Segmente SG des Solartrackers ST über eine von einem Motor M angetriebene, zentral in West-Ost-Richtung verlaufende Schubstange miteinander gekoppelt, die es ermöglicht, die Modulorientierung mit dem Tagesverlauf von Ost nach West dem Sonnenstand anzupassen.

Bei Sonnenaufgang sind also alle Photovoltaikmodule auf dem Solartracker ST nach Osten orientiert. Im Tagesverlauf wird die Neigung der Photovoltaikmodule dann bestmöglich dem aktuellen Sonnenstand angepasst, bis die Photovoltaikmodule bei Sonnenuntergang nach Westen orientiert sind. Die Nachverfolgung des Sonnenstands erfolgt bei den Solartrackern ST beispielsweise durch eine einachsige Drehung der Segmente SG der Solartracker ST.

Die Figur 4 zeigt eine Darstellung eines Solartrackers eines Photovoltaik-Freiflächenkraftwerks gemäß einer möglichen Ausführungsform des erfindungsgemäßen Verfahrens.

Ein Solartracker ST umfasst einen Flügel bzw. Wing T, auf dem die Photovoltaikmodule montiert werden und ein Fundament F, mit welchem der Solartracker ST im Boden verankert wird.

Ein Motor M wird beispielsweise zwischen dem Fundament F und dem Wing T in der Höhe HST angebracht und kann über eine Schubstange SC den Wing T drehen, beispielsweise über einen Winkelbereich von +/- 45°. Die Schubstange SC verläuft in der Mitte der Segmente SG in West-Ost-Richtung und unterteilt so jedes Segment SG in einen nördlichen und einen südlichen Wing T.

Zur Spezifizierung des Trackerdesigns des Solartrackers ST durch den Anwender gehört beispielsweise die Auswahl einer Vielzahl von Design- und Konfigurationsparametern des Solartrackers ST, beispielsweise die Auswahl des verwendeten Modultyps, die Festlegung der Anzahl an Photovoltaikmodulen pro Wing T, inklusive deren Montage auf dem Gestell, der Abstand zwischen einem nördlichen und einem südlichen Wing T eines Segments SG, die Abstände zwischen den Segmenten SG in West-Ost-Richtung, die Anzahl an Segmenten SG in dem Solartracker ST und die Verkabelung des Equipments innerhalb des Solartrackers ST, wie etwa die Verschaltung der Strings oder die Verschaltung der Anschlusskästen oder der Wechselrichter.

Insbesondere ergeben sich aus dem Trackerdesign des Solartrackers ST die Ausdehnungen des rechteckigen Umrisses des Solartrackers ST. Bei der Konfiguration des Trackerdesigns des Solartrackers ST muss der Anwender sowohl auf die elektrische Kompatibilität des verwendeten Equipments als auch auf Beschränkungen hinsichtlich der Ausdehnungen des Solartrackers ST in West-Ost- und Nord-Süd-Richtung beispielsweise aufgrund von zulässigen Windlasten achten.

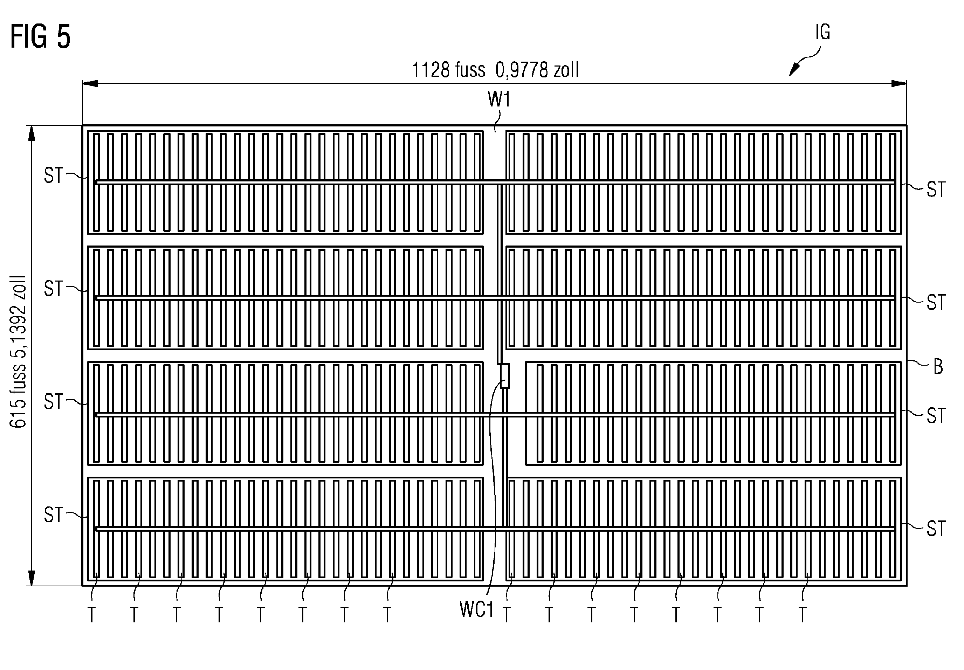

Die Figur 5 zeigt eine Darstellung einer Inverter-Gruppe eines Photovoltaik-Freiflächenkraftwerks gemäß einer möglichen Ausführungsform des erfindungsgemäßen Verfahrens.

Die Figur 5 veranschaulicht eine Inverter-Gruppe IG mit acht Solartrackern ST, die aufgrund ihrer rechteckigen Anordnung als Standardblock B bezeichnet wird. Im Zentrum der Figur 5 ist ein Wechselrichter-Container WC1 dargestellt. Die Figur 5 stellt zudem die Kabelführung innerhalb der Inverter-Gruppe IG dar. Es wird angedeutet, wie die Kabel von den Solartrackern ST zum Wechselrichter-Container WC1 geführt werden. In der Mitte des Photovoltaik-Freiflächenkraftwerks PV verläuft in Nord-Süd-Richtung ein Kabel- und Serviceweg W1.

Ein Wechselrichter des Photovoltaik-Freiflächenkraftwerks PV weist beispielsweise mehrere Gleichstrom-Eingänge auf, an die mehrere parallel geschaltete Strings angeschlossen werden. Die Zahl der an einen Wechselrichtereingang anzuschließenden Strings ergibt sich aus den Moduldaten des Photovoltaikmoduls, aus den Daten des Wechselrichters und den Konfigurationsparametern und ist innerhalb eines vorgegebenen Korridors flexibel. Dies ist bei der Festlegung des Trackerdesigns des Solartrackers ST zu berücksichtigen.

Jedem Wechselrichter wird eine vom Anwender definierte Anzahl an Solartrackern ST zugeordnet, die eine sogenannte Inverter-Gruppe IG bilden. Die Anzahl an Solartrackern ST in einer Inverter-Gruppe IG wird jeweils dadurch festgelegt, dass die resultierende Stromstärke, die an den Wechselrichter der Inverter-Gruppe IG geleitet wird, mit dessen elektrischer Spezifikation kompatibel ist und die Wechselrichterkapazitäten optimal ausnutzt.

Es kann zu diesem Zweck auch vorteilhaft sein, unterschiedlich konfigurierte Solartracker ST in einer Inverter-Gruppe IG zusammenzufassen. So kann die Anzahl an Segmenten SG pro Solartracker ST innerhalb einer Inverter-Gruppe IG variieren, um die Kapazität des Wechselrichters optimal auszunutzen.

Um eine kostengünstige und effiziente Verkabelung zu ermöglichen, sollte der Wechselrichter-Container stets nah am Schwerpunkt der Inverter-Gruppe IG positioniert werden. Daher darf aus einem Solartracker ST auch eine gewisse Anzahl von Segmenten SG eliminiert werden, so dass auf dem dadurch gewonnen Platz der Wechselrichter-Container WC1 der Inverter-Gruppe IG vorgesehen werden kann.

Um die Verkabelung zu vereinfachen und Material zu sparen, werden die Kabel mehrerer Strings in sogenannten Generatoranschlusskästen gebündelt. Analog werden die Kabel mehrerer Generatoranschlusskästen in sogenannten Koppelkästen zusammengeführt. Jeder Koppelkasten wird dann auf einen Gleichstromeingang eines Wechselrichters geleitet. Ein Ziel bei der Platzierung der Solartracker ST und der Wechselrichter ist es, möglichst gute Voraussetzungen für eine möglichst einfache, effiziente und kostengünstige Gleichstrom-Verkabelung zu schaffen.

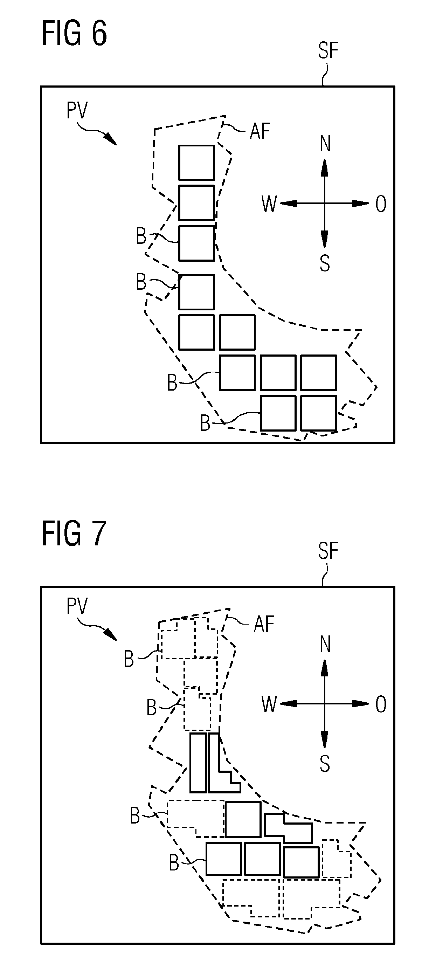

Die Figuren 6 und 7 zeigen zwei unterschiedliche Anlagenlayouts, die gemäß einer möglichen Ausführungsform der erfindungsgemäßen Vorrichtung aus unterschiedlichen Vorgaben hinsichtlich der Anordnung der Solartracker in den Inverter-Gruppen resultieren. So durften bei der Erstellung der in der Figur 6 gezeigten Konfiguration des Photovoltaik-Freiflächenkraftwerks PV als Inverter-Gruppen IG gemäß einer Konfigurationsregel nur regelmäßige Standardblöcke verwendet werden (Anwendungsfall "Standardblöcke").

Demgegenüber zeigt Figur 7 wie die Solartracker einer Inverter-Gruppe beispielsweise auch angeordnet sein dürfen, wenn bei der Gruppierung keine Einschränkungen zu beachten sind (Anwendungsfall "Beliebige Inverter-Gruppen").

Die Standardblöcke in Figur 6 ermöglichen einen möglichst einfachen und effizienten Anlagenaufbau und -service. Die zur Verfügung stehende Fläche, insbesondere an ihren Rändern, ist jedoch nicht besonders effizient genutzt, so dass bei der in der Figur 6 gezeigten Anlage im Vergleich zur möglichen Anlagenfläche wenig Leistung installiert ist.

In der Figur 7 ist ein Anwendungsfall ohne Einschränkungen an die Solartrackeranordnung in den Inverter-Gruppen IG des Photovoltaik-Freiflächenkraftwerks PV dargestellt. Es ist leicht zu erkennen, dass im Vergleich zur Anlage aus Figur 6 mehr Inverter-Gruppen verortet werden konnten und die Anlage somit mehr Leistung besitzt. Allerdings führen die resultierenden unregelmäßigen Anlagenstrukturen zu einem deutlich komplexeren Anlagenaufbau und im Mittel auch zu längeren Kabeln.

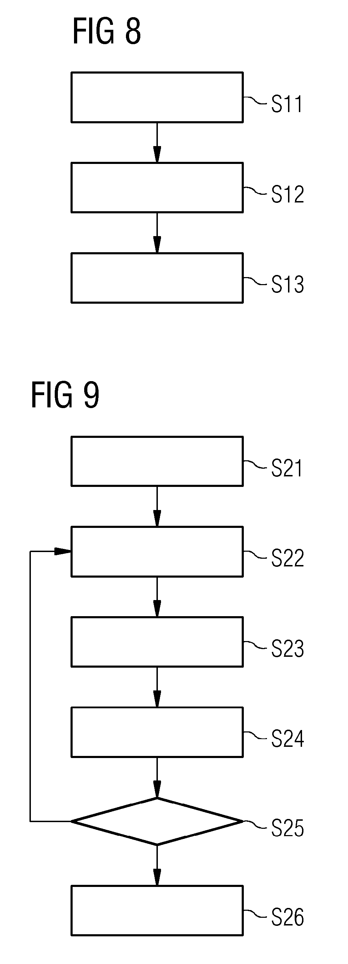

Die Figuren 8 und 9 zeigen jeweils eine Darstellung eines Ablaufdiagramms einer möglichen Ausführungsform des erfindungsgemäßen Verfahrens zum Erstellen einer Konfiguration eines Photovoltaik-Freiflächenkraftwerks mit Solartrackern, die in Standardblöcken angeordnet werden müssen (Figur 8, Anwendungsfall "Standardblöcke") bzw. die beliebig zu Inverter-Gruppen zusammengefasst werden dürfen (Figur 9, Anwendungsfall "Beliebige Inverter-Gruppen").

Ein Optimierer des Verfahrens zum Erstellen einer Konfiguration eines Photovoltaik-Freiflächenkraftwerks PV mit Solartrackern ST unterteilt das Problem der Anlagenplanung und des Erstellens einer Konfiguration des Photovoltaik-Freiflächenkraftwerks PV in die folgenden Teilprobleme bzw. Teileinheiten:
1. Lokalisierung der durchgängigen West-Ost-Wege des Photovoltaik-Freiflächenkraftwerks PV oder Definition von Streifen für die Solartracker ST des Photovoltaik-Freiflächenkraftwerks PV und Initialisierung der Solartracker-Zentren (sowohl im Anwendungsfall "Standardblöcke" als auch im Anwendungsfall "Beliebige Inverter-Gruppen");
2. Initialisierung der Inverter-Gruppen IG des Photovoltaik-Freiflächenkraftwerks PV (nur im Anwendungsfall "Beliebige Inverter-Gruppen");
3. Optimierung der West-Ost Ausrichtung der Solartracker-Zentren (sowohl im Anwendungsfall "Standardblöcke" als auch im Anwendungsfall "Beliebige Inverter-Gruppen"); und
4. Verbesserung der Inverter-Gruppen-Einteilung des Photovoltaik-Freiflächenkraftwerks PV (nur im Anwendungsfall "Beliebige Inverter-Gruppen").

Für den Anwendungsfall "Standardblöcke" ergibt sich damit das in Figur 8 gezeigte Ablaufdiagramm.

Als ein erster Verfahrensschritt erfolgt im Anwendungsfall "Standardblöcke" ein Lokalisieren S11 der durchgängigen West-Ost-Wege und anschließend ein Initialisieren der Zentren der Solartracker ST.

Als ein zweiter Verfahrensschritt erfolgt im Anwendungsfall "Standardblöcke" ein Optimieren S12 der West-Ost-Ausrichtung der Zentren der Standardblöcke bzw. Solartracker ST.

Als ein dritter Verfahrensschritt erfolgt im Anwendungsfall "Standardblöcke" ein Beenden S13 des Verfahrens zum Erstellen einer Konfiguration eines Photovoltaik-Freiflächenkraftwerks mit Solartrackern.

Für den Anwendungsfall "Beliebige Inverter-Gruppen" ergibt sich das in Figur 9 gezeigte Ablaufdiagramm.

Als ein erster Verfahrensschritt erfolgt im Anwendungsfall "Beliebige Inverter-Gruppen" ein Lokalisieren S21 der durchgängigen West-Ost-Wege und ein Initialisieren der Zentren der Solartracker ST.

Als ein zweiter Verfahrensschritt erfolgt ein Initialisieren S22 der Inverter-Gruppen IG.

Als ein dritter Verfahrensschritt erfolgt im Anwendungsfall "Beliebige Inverter-Gruppen" ein Optimieren S23 der West-Ost-Ausrichtung der Zentren der Solartracker ST.

Als ein vierter Verfahrensschritt erfolgt ein Optimieren S24 der Initialisierung der Inverter-Gruppen IG.

Als ein fünfter Verfahrensschritt erfolgt ein Überprüfen S25, ob das im vierten Verfahrensschritt vorgenommene Optimieren noch zu einer Verbesserung geführt hat.

Falls eine Verbesserung vorliegt, wird das Verfahren ab dem dritten Verfahrensschritt S23 wiederholt. Andernfalls wird das Verfahren zum Erstellen einer Konfiguration eines Photovoltaik-Freiflächenkraftwerks mit Solartrackern mit dem sechsten Verfahrensschritt fortgeführt.

Als ein sechster Verfahrensschritt erfolgt ein Beenden S26 des Verfahrens zum Erstellen einer Konfiguration eines Photovoltaik-Freiflächenkraftwerks mit Solartrackern.

Zur Lokalisierung der durchgängigen West-Ost-Wege bzw. zur Definition von Solartracker-Streifen und zur Initialisierung der Zentren der Solartracker ST (Teilschritte S11 bzw. S21) erfolgt zunächst eine Diskretisierung des Geländes G in Nord-Süd-Richtung, beispielsweise mit einem Geländepunkteraster mit genügend fein gewählten, festen Abständen des Punktrasters.

Für jede der aus der Diskretisierung resultierenden y-Koordinaten wird anschließend überprüft, wie viele Solartracker ST für den Anwendungsfall "beliebige Inverter-Gruppen" bzw. Standardblöcke für den Anwendungsfall "Standardblöcke" auf der zugehörigen y-Koordinate innerhalb des Geländes G platziert werden können und welche Restkapazität in dem zur y-Koordinate gehörenden Streifen übrig bleibt.

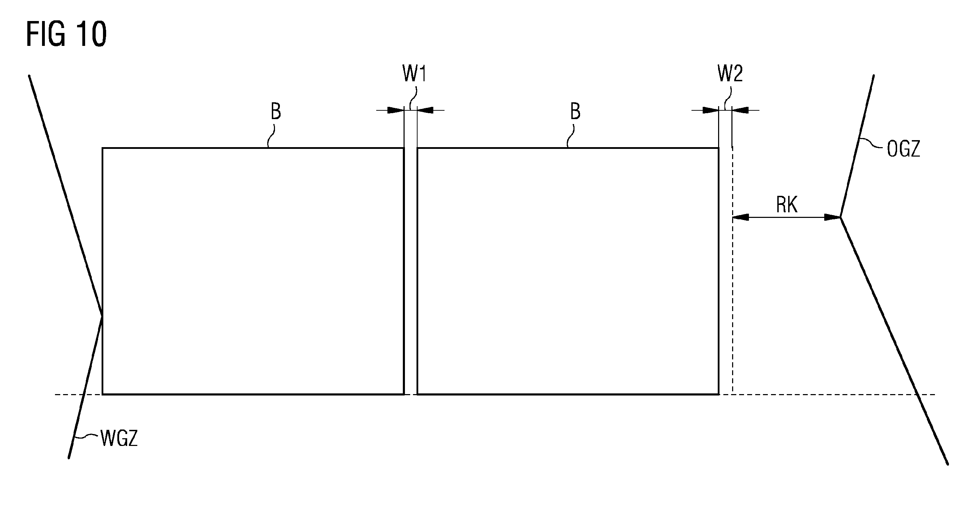

Die Figur 10 zeigt eine Darstellung eines Detailausschnitts zur Platzierung der Solartracker bzw. Standardblöcke gemäß einer möglichen Ausführungsform des erfindungsgemäßen Verfahrens.

Als y-Koordinate dient dabei beispielsweise jeweils immer die untere y-Koordinate des rechteckigen Umrisses eines Solartrackers ST bzw. eines Standardblocks B, wie in Figur 10 dargestellt.

Das Gelände G wird durch eine östliche Gebietsgrenze OGZ und eine westliche Gebietsgrenze WGZ begrenzt.

Sind die Streifenkapazitäten für alle aus der Diskretisierung resultierenden y-Koordinaten bestimmt, müssen anschließend die y-Koordinaten ausgewählt werden, die in der Anlage tatsächlich als untere y-Koordinaten der Solartracker ST bzw. Standardblöcke B dienen werden.

Die vorrangige Zielsetzung bei dieser Auswahl ist es, möglichst viele Solartracker ST bzw. Standardblöcke B in der zur Verfügung stehenden Fläche verorten zu können. Als untergeordnetes Ziel wird eine möglichst hohe Restkapazität RK in den ausgewählten Streifen angestrebt, um möglichst viel Spielraum bei der späteren Optimierung der x-Koordinaten der Solartracker ST bzw. Standardblöcke B zu haben.

Dieses Teilproblem wird mit Hilfe einer dynamischen Programmierung gelöst.

In der Vorwärtsrechnung startet man am Südrand des Geländes G und hangelt sich mit der im Folgenden beschriebenen Methodik bis zum Nordrand des Geländes G voran. Für jede Reihe wird überprüft, welche südlich von ihr gelegene Reihe die günstigste südliche Nachbarreihe wäre, damit die kumulierte Anzahl an Solartrackern ST bzw. Standardblöcken B bis zur aktuellen y-Koordinate maximal ist und als untergeordnetes Ziel die kumulierte Restkapazität RK größtmöglich ausfällt.

Dabei ist insbesondere auch zu beachten, dass zwischen zwei in Nord-Süd-Richtung benachbarten Streifen immer mindestens eine Wegbreite WB1, WB2 Platz gewahrt werden muss, der dann den durchgängigen West-Ost-Wegen durch das Gelände entspricht. Das Resultat der Vorwärtsrechnung ist also eine Tabelle, die für jede y-Koordinate nicht nur die günstigste, zulässige, südliche Nachbarreihe angibt sondern auch die maximale kumulierte Anzahl an Solartrackern ST bzw. Standardblöcken, die vom südlichen Geländerand bis zur betreffenden y-Koordinate im Gelände G platzierbar ist, sowie die kumulierte Restkapazität RK der betreffenden Streifen.

In der Rückwärtsrechnung wird nun ausgehend von der y-Koordinate mit der größten kumulierten Anzahl an Solartrackern ST bzw. Standardblöcken B und der größten kumulierten Restkapazität RK - welche nahe am Nordrand des Geländes liegt - zurückverfolgt, welches die jeweils günstigsten südlichen Nachbarreihen sind. Auf diese Weise erhalt man die y-Koordinaten für alle Ost-West-Streifen durch das Gelände G und gleichzeitig die Koordinaten der durchgängigen West-Ost-Wege.

In allen ausgewählten Streifen wird nun überschneidungsfrei die zugehörige Anzahl an Solartrackern ST bzw. Standardblöcken B verortet, insbesondere werden dabei die zugehörigen x-Koordinaten initialisiert. Dies kann beispielsweise durch eine möglichst westliche Orientierung aller Solartracker ST bzw. Standardblöcke B erfolgen, wie es auch in Figur 10 dargestellt ist. Zu beachten sind erneut lediglich die einzuhaltenden Wegbreiten WB1, WB2 zwischen je zwei benachbarten Solartrackern ST bzw. Standardblöcken B.

Schematisch lässt sich das Verfahren zum hier beschriebenen Teilproblem wie folgt zusammenfassen:
Zur Modellierung erfolgt zunächst das Bereitstellen eines Input. Das Input umfasst beispielsweise Geländedaten, eine Dimensionierung der Solartracker ST bzw. der Standardblöcke und der Wegbreiten.

Ferner werden bei der Modellierung die folgenden Restriktionen festgelegt: Überschneidungsfreie Platzierung der Solartracker ST bzw. der Standardblöcke B, Einhaltung der Wegbreiten zwischen den Streifen und den Solartrackern ST bzw. Standardblöcken B.

Als Zielfunktionen bei der Modellierung zur Optimierung einer Anlagenlayouteigenschaft des Photovoltaik-Freiflächenkraftwerks PV werden eingesetzt: eine Maximierung der Anzahl platzierter Solartracker ST bzw. der Standardblöcke B, eine Maximierung der über alle ausgewählten Streifen kumulierten Restkapazität.

Dies führt zu einem Daten-Output in Form eines erstellten Anlagenlayouts. Das Daten-Output umfasst beispielsweise y-Koordinaten der Solartracker-Streifen, y-Koordinaten der durchgängigen West-Ost-Wege, Initiale Koordinaten der Solartracker ST bzw. der Standardblöcke B.

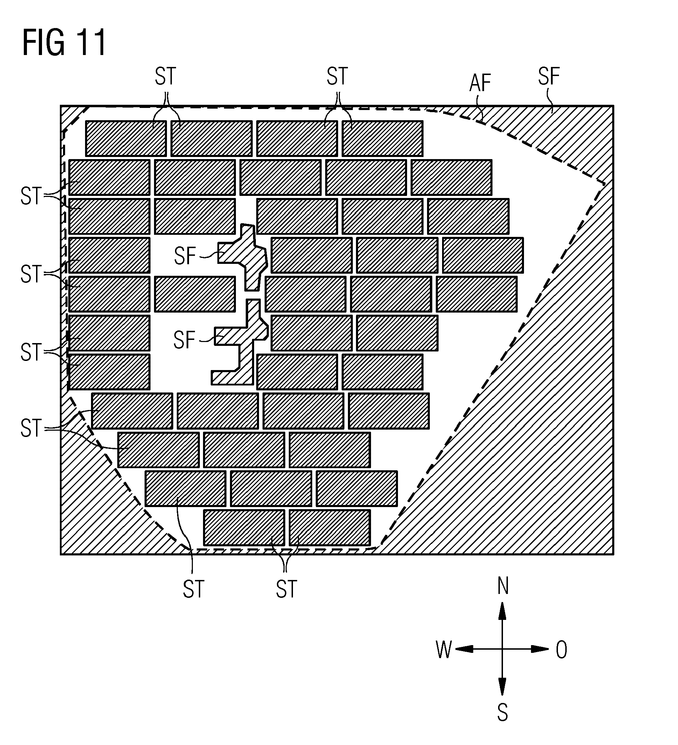

Die Figur 11 ist ein mögliches Ergebnis für den Anwendungsfall "beliebige Inverter-Gruppen". Die Figur 11 zeigt das Resultat dieses gelösten Teilproblems zur Optimierung einer Anlagenlayouteigenschaft des Photovoltaik-Freiflächenkraftwerks PV für ein Gebiet mit zwei zentral gelegenen Sperrflächen SF.

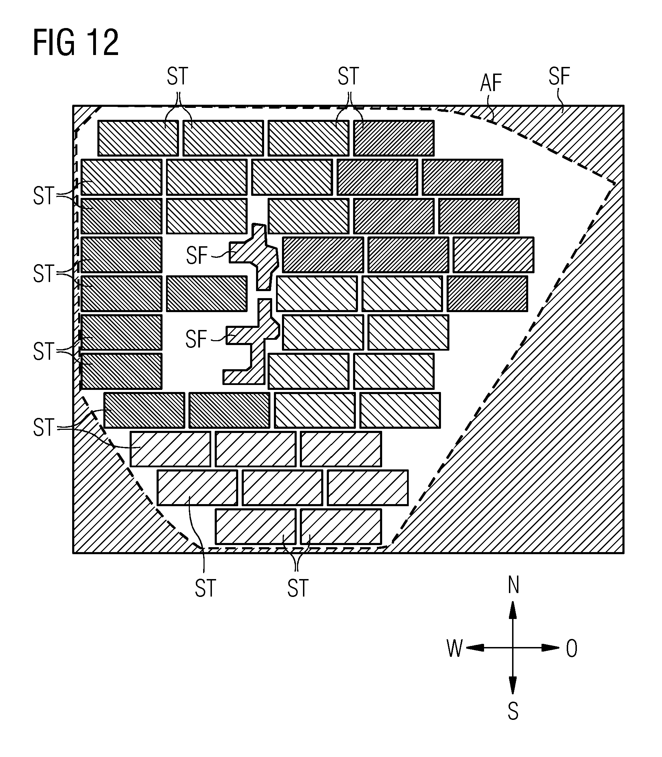

Die Figur 12 zeigt einen Detailausschnitt eines möglichen Anlagenlayouts einer Konfiguration eines Photovoltaik-Freiflächenkraftwerks gemäß einer möglichen Ausführungsform des erfindungsgemäßen Verfahrens.

Das zur Berechnung der in Figur 12 dargestellten Konfiguration verwendete Verfahren umfasst eine Initialisierung der Inverter-Gruppen IG (Teilschritt S22) und basiert auf den im vorangegangenen Teilproblem bestimmten Koordinaten der Solartracker ST, die in diesem Teilschritt nicht verändert werden. Ziel dieses Teilschrittes ist es, die Solartracker in möglichst kompakte Inverter-Gruppen einzuteilen.

Da die Anzahl N an platzierten Solartrackern ST im Allgemeinen kein Vielfaches von der Anzahl M an Solartrackern ST pro Inverter-Gruppe IG ist, müssen zunächst die eventuell überzähligen eliminiert werden, beispielsweise durch eine Division mit Rest. Zielsetzung bei der Entfernung kann es dabei beispielsweise sein, die Solartracker ST mit den wenigsten unmittelbaren Nachbarn zu entfernen oder aber die Fläche, die durch die nicht eliminierten Solartracker ST belegt ist, möglichst kompakt zu gestalten, das heißt man möchte eine möglichst geringe Ausdehnung der tatsächlich genutzten Fläche in Ost-West- bzw. Nord-Süd- Richtung erreichen.

Beide vorgeschlagenen Ziel-Alternativen können im Rahmen von einfachen Greedy-Heuristiken oder gemischt-ganzzahligen Programmen realisiert werden. Nach der Entscheidung, welche Solartracker ST bei der Initialisierung der Inverter-Gruppen IG nicht zu berücksichtigten sind, werden die Inverter-Gruppen IG zunächst beispielsweise mit Hilfe einer Greedy-Heuristik ermittelt.

Hierbei kann man beispielsweise so vorgehen, dass man jeweils unter den noch nicht einer Inverter-Gruppe IG zugeordneten Solartrackern ST den mit den wenigsten Nachbarn bestimmt und für diesen aus den noch verbleibenden und noch nicht zugeordneten Solartracker ST die lokal bestmögliche, das heißt beispielsweise möglichst kompakte, Inverter-Gruppe IG bildet. Diese Methodik wird dann solange fortgesetzt, bis alle nicht eliminierten Solartracker ST einer Inverter-Gruppe IG zugeordnet sind.

Im Anschluss an die beschriebene Greedy-Heuristik kann man mit einem lokalen Verbesserungsverfahren versuchen, die Initialisierung der Inverter-Gruppen IG zu verbessern. Dies kann beispielsweise mit einem einfachen Location-Allocation-Verfahren geschehen, welches zwei Schritte umfasst, die solange abwechselnd durchgeführt werden, bis man keine Verbesserungen mehr erzielen kann.

In einem ersten Schritt bestimmt man jeweils für alle aktuellen Inverter-Gruppen IG den Schwerpunkt aller Solartracker ST dieser Inverter-Gruppe IG.

Im zweiten Schritt fixiert man die berechneten Schwerpunkte der Inverter-Gruppen IG und nimmt dann eine Neuzuordnung der Solartracker ST zu den Inverter-Gruppen IG vor. Dies kann mit Hilfe eines gemischt-ganzzahligen Verfahrens erfolgen, dessen Zielsetzung es ist, die Summe aller Distanzen der Solartracker ST zu den fixierten Schwerpunkten der zugehörigen Inverter-Gruppen IG zu minimieren. Als Nebenbedingung ist dabei lediglich die Einhaltung der Größen der Inverter-Gruppen IG zu berücksichtigen.

Eine mögliche andere Vorgehensweise bei der Initialisierung der Inverter-Gruppen IG besteht darin, alternativ die oben beschriebene Greedy-Heuristik direkt auf alle verfügbaren Solartracker ST anzuwenden. Dabei wird in diesem Fall auf die vorgelagerte Eliminierung überzähliger Solartracker ST verzichtet. Die Greedy-Heuristik endet dann natürlich, wenn nicht mehr genügend noch nicht zugeordnete Solartracker ST für die Bildung einer weiteren Gruppe der Solartracker ST existieren.

Der wesentliche Teilschritt beim Verfahren zur Initialisierung der Inverter-Gruppen liegt somit in der beschriebenen Greedy-Heuristik. Sowohl auf die vorgelagerte Eliminierung überzähliger Solartracker ST als auch auf das beschriebene nachgelagerte lokale Verbesserungsverfahren kann bedarfsweise auch verzichtet werden. Schematisch lässt sich das Verfahren zum hier beschriebenen Teilproblem zur Optimierung einer Anlagenlayouteigenschaft des Photovoltaik-Freiflächenkraftwerks PV wie folgt zusammenfassen:
Bei der Modellierung werden zur Initialisierung der Inverter-Gruppen die Koordinaten der Solartracker ST und jeweils die Anzahl an Solartrackern ST pro Inverter-Gruppe IG verwendet.

Als Restriktion dient, dass jede Inverter-Gruppe IG genau die vom Anwender vorgegebene Anzahl an Solartrackern ST aufweist. Als Zielfunktionen werden eine Minimierung der Distanzen der Solartracker ST innerhalb einer Inverter-Gruppe IG zum zugehörigen Schwerpunkt der Inverter-Gruppe IG und eine Verbesserung der Kompaktheit der ermittelten Inverter-Gruppe IG, das heißt eine möglichst geringe Ausdehnung der Inverter-Gruppe IG in x- und y-Richtung, verwendet.

Als Output des Verfahrens wird dadurch eine Initialisierung der Inverter-Gruppen IG erreicht.

Als Lösungsverfahren werden Greedy-Heuristiken, gemischt ganzzahlige Programme und lokale Lösungsverfahren oder Kombinationen davon verwendet.

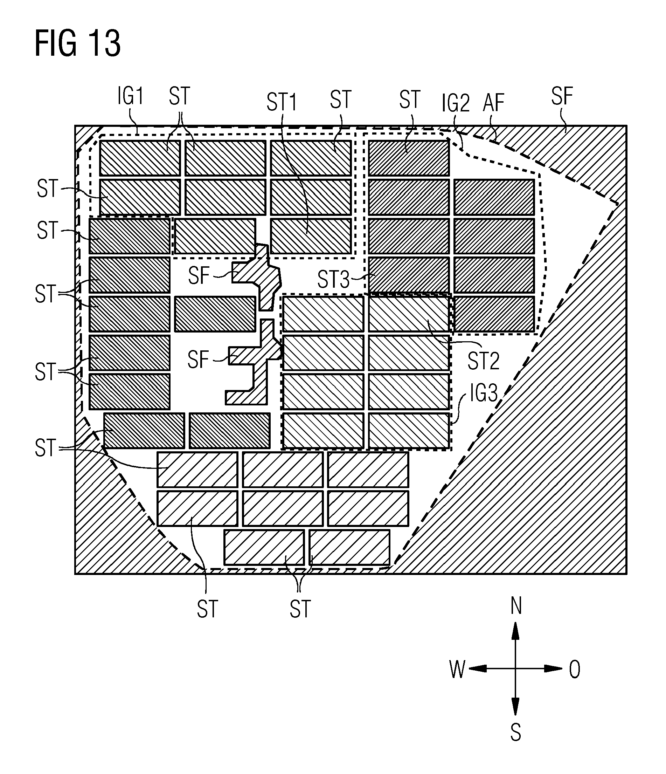

Die Figur 13 zeigt einen Detailausschnitt eines möglichen Anlagenlayouts einer Konfiguration eines Photovoltaik-Freiflächenkraftwerks gemäß einer möglichen Ausführungsform des erfindungsgemäßen Verfahrens.

Das zur Berechnung der in Figur 13 dargestellten Konfiguration verwendete Verfahren hat als grundlegende Zielsetzung eine optimierte West-Ost-Ausrichtung der Solartracker-Zentren (Teilschritt S12 bzw. S23).

Dies schafft möglichst gute Voraussetzungen für eine einfache, effiziente und kostengünstige Verkabelung. Hierfür ist es bei der gleichstromseitigen Verkabelung vorteilhaft, innerhalb der Inverter-Gruppen IG möglichst durchgängige Nord-Süd-Wege zu haben. Im Anwendungsfall "Standardblöcke" ist dies aufgrund der regelmäßigen Anordnung aller Solartracker ST der Inverter-Gruppe IG stets der Fall.

Im Anwendungsfall "beliebige Inverter-Gruppen" sollte man dagegen die verfügbaren Flexibilität hinsichtlich der Anordnung der Solartracker ST in x-Richtung dazu nutzen, den Solartracker ST in einer Inverter-Gruppe IG, die unterschiedliche y-Koordinaten besitzen, möglichst gleiche x-Koordinaten zuzuweisen.

Das bedeutet, dass sich die Solartracker ST einer Inverter-Gruppe IG, die in unterschiedlichen Streifen liegen, hinsichtlich ihrer West-Ost-Ausrichtung aneinander orientieren müssen.

Da die gleichstromseitige Verkabelung deutlich mehr Kabel umfasst als die wechselstromseitige Verkabelung eines Photovoltaik-Freiflächenkraftwerks, haben die durchgängigen Nord-Süd-Wege innerhalb der Inverter-Gruppe IG höchste Priorität.

Trotzdem lasst sich das beschriebene Prinzip auch von den einzelnen Solartracker ST einer Inverter-Gruppe IG auf ganze Inverter-Gruppen IG übertragen, die sich hinsichtlich ihrer West-Ost-Ausrichtung dann ebenfalls aneinander orientieren.

Dies gilt insbesondere für den Anwendungsfall "Standardblöcke", da die Nord-Süd-Wege innerhalb der Inverter-Gruppen IG dort ja ohnehin stets durchgängig sind und man bei der Optimierung der x-Koordinaten aufgrund des im Allgemeinen geringeren Flächenbelegungsgrades im Vergleich zu dem Flächenbelegungsgrad im Anwendungsfall "beliebige Inverter-Gruppen" häufig auch mehr Spielraum für die Verortung der Solartracker ST bzw. der Standardblöcke B zur Verfügung hat.

Sollte es hinsichtlich der oben angeführten Zielsetzung für ein Photovoltaik-Freiflächenkraftwerk annähernd gleich gut geeignete Konfigurationen geben, wird vorzugsweise stets diejenige gewählt werden, die bezüglich der tatsächlich genutzten Fläche die geringste Ausdehnung in West-Ost-Richtung besitzt, da so die Länge der benötigten Wechselstrom-führenden Kabel so kurz wie möglich gehalten werden kann.

Ein geeignetes Verfahren zur Lösung des beschriebenen Teilproblems ist die gemischt-ganzzahlige Programmierung. Dabei werden mit Hilfe von binären, das heißt speziellen ganzzahligen Variablen, die verschiedenen Orientierungsalternativen der Solartracker ST modelliert. Je nachdem welche Alternative bei der Optimierung gewählt wird, orientiert sich ein Solartracker ST dann beispielsweise entweder an seinem linken oder an seinem rechten oberen Nachbarn.

Welche Nebenbedingungen bei der gemischt-ganzzahligen Programmierung zu berücksichtigt sind, geht aus der folgenden schematischen Zusammenfassung des Verfahrens zur Optimierung der West-Ost-Ausrichtung der Zentren der Solartracker ST hervor.

Bei der Modellierung werden die Geländegrenzen der Anlagenfläche AF inklusive der Sperrflächen SF des Geländes G, aktuelle Inverter-Gruppen IG, y-Koordinaten aller Solartracker ST, Wegbreiten WB1, WB2...WBn der Kabel- und Servicewege des Photovoltaik-Freiflächenkraftwerks PV als Input benötigt.

Als Restriktion dient beispielsweise eine Überschneidungsfreie Platzierung der Solartracker ST aller Inverter-Gruppen IG oder die Konfigurationsregel, dass Geländegrenzen des Geländes G nicht verletzt werden dürfen oder dass die Wegbreiten WB1, WB2...WBn zwischen den Streifen und Solartrackern ST bzw. Standardblöcken B des Photovoltaik-Freiflächenkraftwerks PV einzuhalten sind.

Ferner kann als Restriktion angegeben werden, dass die Streifenzugehörigkeit bzw. die y-Koordinate aller Solartracker ST bzw. aller Standardblöcken B des Photovoltaik-Freiflächenkraftwerks PV unverändert bleibt, das heißt nur die x- Koordinaten sind variabel.

Beim Anwendungsfall "Standardblöcke" bleibt die relative Lage aller Solartracker ST bzw. der Standardblöcken B einer Inverter-Gruppe IG des Photovoltaik-Freiflächenkraftwerks PV zueinander unverändert.

Als Zielfunktionen dienen die folgenden Zielfunktionen, welche hinsichtlich der Priorisierung wie folgt geordnet sind, beginnend bei der Zielfunktion mit der höchsten Priorität:
- möglichst geradlinig verlaufende Nord-Süd-Wege innerhalb der Inverter-Gruppen IG des Photovoltaik-Freiflächenkraftwerks PV haben höchste Priorität, damit sich die gleichstromseitige Verkabelung möglichst einfach gestaltet. Im Vergleich dazu ergibt sich eine geringere Priorität für Inverter-Gruppen-übergreifende, geradlinige Nord-Süd-Wege, die zusätzlich die Wechselstrom-Verkabelung vereinfachen;
- möglichst geringe Ausdehnung aller Inverter-Gruppen IG des Photovoltaik-Freiflächenkraftwerks PV in West-Ost-Richtung; und
- möglichst geringe Ausdehnung der tatsachlich von dem Photovoltaik-Freiflächenkraftwerk PV genutzten Anlagenfläche AF.

Als Output werden exakte Positionen aller Solartracker ST bzw. aller Standardblöcke B des Photovoltaik-Freiflächenkraftwerks PV ausgegeben. Als Lösungsverfahren kommt die gemischt ganzzahlige Programmierung zum Einsatz.

Die Figur 13 veranschaulicht die Inverter-Gruppen-Platzierungen, die man als Resultat der Optimierung der x-Koordinaten für die in Figur 12 dargestellte Ausgangssituation erhält.

Als nächste Teileinheit wird eine Verbesserung der Inverter-Gruppen-Einteilung vorgenommen (Teilschritt S24).

Zielsetzung bei dieser Teileinheit ist es, ausgehend von den aktuellen Positionen der Solartracker ST, wobei die Positionen der Solartracker ST in diesem Teilschritt nicht geändert werden, Verbesserungen an der aktuellen Inverter-Gruppen-Zuordnung vorzunehmen, um Inverter-Gruppen IG mit einem möglichst kompakten Umriss zu erhalten und kürzere Distanzen von den Solartracker ST zu den Inverter-Gruppen-Schwerpunkten zu erhalten.

Hierfür werden im Folgenden drei schnelle Austauschverfahren beschrieben.

Beim sogenannten 2-Swap-Verfahren wird für jedes Paar von zwei Solartrackern ST aus unterschiedlichen Inverter-Gruppen IG überprüft, ob eine Vertauschung der Inverter-Gruppen-Zuordnung für diese beiden Solartracker ST hinsichtlich der im vorangegangenen Absatz geschilderten Ziele zu einer Verbesserung führt. Ist dies der Fall, wird eine entsprechende Vertauschung durchgeführt, andernfalls nicht.

Das sogenannte 3-Swap-Verfahren basiert größtenteils auf dem 2-Swap-Verfahren, nur dass hier die Inverter-Gruppen-Zuordnungen von drei Solartrackern ST aus unterschiedlichen Inverter-Gruppen IG des Photovoltaik-Freiflächenkraftwerks PV zyklisch vertauscht werden.

Gehören die Solartracker ST1, ST2 und ST3 also in der ursprünglichen Zuordnung zu den Inverter-Gruppen IG1, IG2 und IG3, so wird überprüft, ob die zyklische Vertauschung der Inverter-Gruppen-Zuordnungen hinsichtlich der oben genannten Ziele zu einer Verbesserung führen oder nicht.

Eine entsprechende Überprüfung kann für alle Dreier-Gruppen von den Solartrackern ST aus unterschiedlichen Inverter-Gruppen IG erfolgen.

Dem Einwechslungs-Verfahren liegt eine andere Idee zugrunde: Hier wird überprüft, ob es im Gelände G beim aktuellen Layout noch Platzreserven gibt, die für die Positionierung eines Solartrackers ST ausreichen, der dann einen im aktuellen Layout existierenden Solartracker ST in dessen Inverter-Gruppe IG ersetzen kann, falls sich daraus hinsichtlich der oben genannten Ziele eine Verbesserung ergibt.

Solche Platzreserven können existieren, falls bei der Initialisierung der Inverter-Gruppen IG nicht alle Solartracker ST einer Inverter-Gruppe IG zugeordnet werden konnten. Natürlich sind bei der Platzierung des neuen Solartrackers ST die üblichen Platzierungsregeln hinsichtlich einer Überschneidung der Geländegrenzen, der West-Ost-Streifen und der Wegbreiten zu beachten. Schematisch lassen sich die beschriebenen Austauschverfahren wie folgt zusammenfassen:
Bei der Modellierung dienen hierbei als Input: die exakten Positionen aller Solartracker, die aktuelle Inverter-Gruppe IG, die Anzahl an Solartracker ST pro Inverter-Gruppe IG, die Geländegrenzen inklusiver der Sperrflächen SF und die Dimensionierung der Solartrackern ST sowie die vorgesehenen Wegbreiten.

Als Restriktionen wird die Beibehaltung der Positionen aller verwendeten Solartracker ST verwendet. Ferner dürfen Geländegrenzen nicht verletzt werden. Als weitere Restriktionen wird eine überschneidungsfreie Platzierung der Solartracker ST bzw. der Standardblöcke B festgesetzt und eine Einhaltung der Wegbreiten zwischen den Streifen und Solartracker ST bzw. Standardblöcken B vorgesehen. Ferner sind die durchgängigen West-Ost-Wege durch das Gelände G beizubehalten. Jede Inverter-Gruppe IG umfasst die vom Anwender vorgegebene Anzahl an Solartrackern ST.

Als Zielfunktionen werden die folgenden Funktionen verwendet:
- Minimierung der Distanzen der Solartracker ST innerhalb einer Inverter-Gruppe IG zum zugehörigen Schwerpunkt der Inverter-Gruppe IG; und
- Kompaktierung der ermittelten Inverter-Gruppen IG, d.h. möglichst geringe Ausdehnung der Gruppen in x- und y-Richtung.

Als Output werden dadurch neue Inverter-Gruppen IG hinsichtlich der Gruppierung der Solartracker ST geliefert. Als Lösungsverfahren kommen hierbei das 2-Swap-Verfahren, das 3-Swap- Verfahren und das Einwechslungs-Verfahren zum Einsatz.

Beim 2-Swap-Verfahren erfolgt ein Austausch der Inverter-Gruppen-Zuordnung von zwei bereits platzierten Solartrackern ST aus unterschiedlichen Inverter-Gruppen IG.

Beim 3-Swap-Verfahren erfolgt ein zyklischer Austausch der Inverter-Gruppen-Zuordnung von drei bereits platzierten Solartrackern ST aus unterschiedlichen Inverter-Gruppen IG.

Beim Einwechslung-Verfahren wird innerhalb einer Inverter-Gruppe IG ein existierender Solartracker ST durch einen im vorhandenen Layout neu platzierten Solartracker ST4 ersetzt.

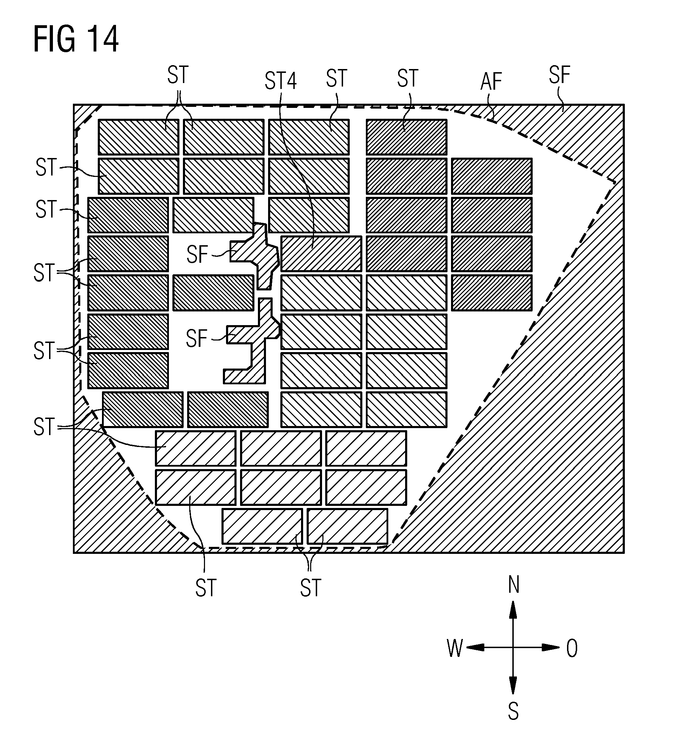

Die Figur 14 zeigt einen Detailausschnitt eines möglichen Anlagenlayouts einer Konfiguration eines Photovoltaik-Freiflächenkraftwerks gemäß einer möglichen Ausführungsform des erfindungsgemäßen Verfahrens.

Die Figur 14 veranschaulicht für die Ausgangslage wie in Figur 13 dargestellt, die Überprüfung einer Einwechslung eines neu platzierten Solartrackers ST4. In diesem Fall würde sich für keine der fünf Inverter-Gruppen IG eine Verbesserung ergeben, wenn der Solartracker ST4 zu einer Inverter-Gruppe IG hinzugenommen und dafür einer der vorhandenen Solartracker ST aus der betreffenden Inverter-Gruppen IG entfernt werden würde.

Da auch bei den Teilschritten "2-Swap" und "3-Swap" keine Veränderungen an diesem Layout vorgenommen werden, bleibt die Verbesserung der Inverter-Gruppen-Einteilung hier erfolglos und das Verfahren terminiert, wie dies in dem in der Figur 9 gezeigten Ablaufdiagramm dargestellt ist.

Im Folgenden wird eine mögliche Erweiterung für das vorgestellte Verfahren beschrieben.

Um beim Anwendungsfall "beliebige Inverter-Gruppen" im Hinblick auf eine effiziente, kostengünstige und einfache Verkabelung bessere Voraussetzungen schaffen zu können, wird im Rahmen dieser Erweiterung ein zusätzlicher Parameter eingeführt, mit dem der Anwender spezifizieren kann, auf wie viele Inverter-Gruppen man bei der Ausnutzung der zur Verfügung stehenden Fläche zugunsten der Flexibilität bei der Optimierung der West-Ost-Ausrichtung der Zentren der Solartracker ST freiwillig verzichtet.

Die Idee besteht also darin, die installierte Nennleistung künstlich zu reduzieren, um dafür eine geschicktere Verkabelung erreichen zu können. Das Verfahren verläuft dann analog zu den vorherigen Ausführungen, nur dass bei der Lokalisierung der durchgängigen West-Ost-Wege, das heißt bei der Streifendefinition, und der Initialisierung der Tracker-Zentren die Anzahl der Solartracker, die eliminiert werden, entsprechend vergrößert wird.

In der Folge werden weniger Inverter-Gruppen im Gelände platziert, was automatisch die Flexibilität hinsichtlich der x-Koordinaten innerhalb der West-Ost-Tracker-Streifen erhöht. Somit vergrößern sich die Chancen auf durchgängige Nord-Süd-Wege innerhalb der Inverter-Gruppen IG bei der Optimierung der West-Ost-Ausrichtung der Tracker-Zentren.

Das im Allgemeinen komplexe Problem der Anlagenlayoutplanung von Photovoltaik-Freiflächenanlage mit Solartrackern wird zusammenfassend also in ein hierarchisches System von kleineren Teilproblemen zerlegt. Anschließend wird die Lösung des Gesamtproblems aus den Lösungen der Teilprobleme zusammengesetzt. Für die Lösung der Teilprobleme wurden maßgeschneiderte mathematische Modelle und Verfahren entworfen, die eine Automatisierung erlauben, Planungszeiten signifikant reduzieren und qualitativ sehr gute Layouts berechnen.

Durch das erfindungsgemäße Verfahren kann die bislang sehr aufwendige, für jede Anlage individuell durchzuführende Layoutplanung deutlich vereinfacht, beschleunigt und verbessert werden.

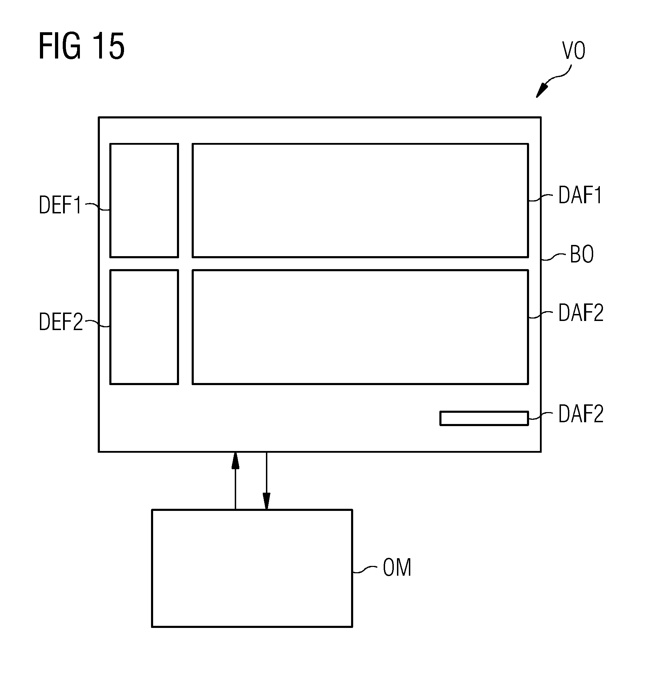

Die Figur 15 zeigt eine Darstellung eines Benutzeroberflächenmoduls zur Dateneingabe gemäß einer möglichen Ausführungsform der erfindungsgemäßen Vorrichtung.

Eine Vorrichtung VO zum Erstellen eines Anlagenlayouts eines Photovoltaik-Freiflächenkraftwerks PV umfasst ein Optimierungsmodul OM und ein Benutzeroberflächenmodul BO.

Beispielsweise werden als Dialogfenster oder Dialogfelder oder Dialogboxen spezielle Fenster in einer grafischen oder zeichenorientierten Benutzerschnittstelle definiert und aufgezeigt.

Beispielsweise umfasst das Benutzeroberflächenmodul BO eine Vielzahl von Dialogfenstern, welche formularartig aufgebaut sind und zur Eingabe von Daten vorgesehen sind. Dazu werden beispielsweise Standard-Widgets wie Datenanzeigefelder DAF1-DAF3 und Checkboxen verwendet.

Das Benutzeroberflächenmodul BO weist ferner Dateneingabefelder DEF1-DEF2 auf und bietet dadurch die erforderlichen Funktionalitäten zur Eingabe und Verwaltung der Grunddaten, wie beispielsweise Daten zu den Solartrackern ST, Daten zu den verwendeten Typen der Wechselrichter oder Daten zu dem Gelände G und gegebenenfalls weitere Daten.

Der Geländedateninputdialog ermöglicht die Definition von Gelände- und Sperrflächenumrissen für das Gelände G.

Ein weiteres Menü kann Funktionalitäten zur Geländedaten- und Komponentenauswahl sowie zur Parametereingabe aufweisen. Außerdem werden beispielsweise Informationen, etwa zu den Ergebnissen einer physikalischen oder schaltungstechnischen Prüfung der Solarzellentischanordnung, dargestellt.

Beispielsweise wird nach Anklicken eines Buttons ein Optimierungslauf gestartet und eine Optimierungsseite wird geöffnet. Es erscheint eine Kurzinformation zum aktuell von dem Optimierungsmodul bearbeiteten Optimierungsauftrag sowie eine Statusanzeige, die über den Programmfortschritt Auskunft gibt.

Nach Beendigung des Optimierungslaufs erscheint eine Kurzzusammenfassung der Ergebnisse. Durch Anklicken eines weiteren Buttons werden die Ergebnisse im Detail aufbereitet. Nach Beendigung der Ergebnisaufbereitung öffnet sich die Reportseite. Die Optimierungsergebnisse können in Form einer Graphik mit Interaktions- und Zoomfunktion oder als Ergebnis- oder Datenlisten angezeigt werden.

Obwohl die Erfindung im Detail durch die vorstehend dargestellten Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

### Bezugszeichenliste

- S1: Bereitstellen
- S2: Initialisieren und anschließendes Optimieren
- S11: Lokalisieren
- S12: Optimieren
- S13: Beenden
- S21: Lokalisieren
- S22: Initialisieren
- S23: Optimieren
- S24: Optimieren
- S25: Überprüfen
- S26: Beenden
- PV: Photovoltaik-Freiflächenkraftwerk
- G: Gelände
- SF: Sperrfläche
- AF: Anlagenfläche
- ST: Solartracker
- SG: Segmente
- M: Motor
- W1: Serviceweg
- T: Wing
- F: Fundament
- SC: Schubstange
- B: Standardblock
- WC1: Wechselrichter-Container
- IG: Inverter-Gruppe
- I: Inverter
- RK: Restkapazität
- WB1,WB2: Wegbreite
- OGZ: östliche Gebietsgrenze
- WGZ: westliche Gebietsgrenze
- IG1 IG3: Inverter-Gruppen
- ST1, ST2, ST3, ST4: Solartracker
- VO: Vorrichtung
- OM: Optimierungsmodul
- BO: Benutzeroberflächenmodul
- DEF1-DEF2: Dateneingabefelder
- DAF1-DAF3: Datenanzeigefelder

## Patentansprüche

1. Verfahren zum Erstellen eines Anlagenlayouts eines Photovoltaik-Freiflächenkraftwerks (PV), welches Kraftwerkskomponenten, insbesondere Solartracker (ST) aufweist, mit folgenden Verfahrensschritten:
- Bereitstellen (S1) von Konfigurationsdaten, welche das Photovoltaik-Freiflächenkraftwerk (PV) und dessen Kraftwerkskomponenten spezifizieren, und von Konfigurationsregeln, welche für das Photovoltaik-Freiflächenkraftwerk (PV) vorgegeben werden, sowie von Konfigurationsparametern, welche die Konfigurationsregeln konkretisieren; und
- Initialisieren und anschließendes Optimieren (S2) einer Auswahl und einer Verortung von benötigten Kraftwerkskomponenten für Anlagenlayouteigenschaften des Photovoltaik-Freiflächenkraftwerks (PV) anhand der bereitgestellten Konfigurationsdaten und der konkretisierten Konfigurationsregeln zur Erstellung des Anlagenlayouts des Photovoltaik-Freiflächenkraftwerks (PV).

2. Verfahren nach Anspruch 1,
wobei zur Erstellung des Anlagenlayouts des Photovoltaik-Freiflächenkraftwerks (PV) ein Berechnen einer Wege-Konfiguration des Photovoltaik-Freiflächenkraftwerks (PV) zum Optimieren einer der Anlagenlayouteigenschaften vorgenommen wird.

3. Verfahren nach einem der Ansprüche 1 oder 2,
wobei zur Erstellung des Anlagenlayouts des Photovoltaik-Freiflächenkraftwerks (PV) ein Berechnen einer Anzahl der Kraftwerkskomponenten des Photovoltaik-Freiflächenkraftwerks (PV) zum Optimieren einer der Anlagenlayouteigenschaften vorgenommen wird.

4. Verfahren nach einem der Ansprüche 1 bis 3,
wobei zur Erstellung des Anlagenlayouts des Photovoltaik-Freiflächenkraftwerks (PV) ein Berechnen einer Verortung der Solartracker (ST) des Photovoltaik-Freiflächenkraftwerks (PV) zum Optimieren einer der Anlagenlayouteigenschaften vorgenommen wird.

5. Verfahren nach einem der Ansprüche 1 bis 4,
wobei zur Erstellung des Anlagenlayouts des Photovoltaik-Freiflächenkraftwerks (PV) ein Berechnen einer Zuordnung der Solartracker (ST) zu Inverter-Gruppen (IG) der Kraftwerkskomponenten des Photovoltaik-Freiflächenkraftwerks (PV) zum Optimieren einer der Anlagenlayouteigenschaften vorgenommen wird.

6. Verfahren nach einem der Ansprüche 4 und 5,
wobei das Berechnen der Verortung der Solartracker (ST) des Photovoltaik-Freiflächenkraftwerks (PV) und das Berechnen der Zuordnung der Solartracker (ST) zu den Inverter-Gruppen (IG) im Zuge eines lokalen Verbesserungsverfahrens wiederholt im Wechsel vorgenommen wird.

7. Verfahren nach einem der Ansprüche 1 bis 6,
wobei eine Maximierung der Anzahl der Solartracker (ST) des Photovoltaik-Freiflächenkraftwerks (PV) zum Optimieren einer der Anlagenlayouteigenschaften vorgenommen wird.

8. Verfahren nach einem der Ansprüche 1 bis 7,
wobei die Erstellung des Anlagenlayouts des Photovoltaik-Freiflächenkraftwerks (PV) eine Prüfung der Kompatibilität der vorgesehenen Kraftwerkskomponenten zueinander umfasst.

9. Verfahren nach einem der Ansprüche 1 bis 7,
wobei als die Konfigurationsdaten Daten zu einer Lage und/oder zu einem Umriss eines für das Photovoltaik-Freiflächenkraftwerk (PV) vorgesehenen Geländes bereitgestellt werden.

10. Verfahren nach einem der Ansprüche 1 bis 8,
wobei zur Erstellung des Anlagenlayouts des Photovoltaik-Freiflächenkraftwerks (PV) ein Optimierungsmodul mit mehreren Algorithmen verwendet wird, welches mehrere Berechnungsverfahren benutzt, die zur Projektierung und zur Einrichtung des Photovoltaik-Freiflächenkraftwerks (PV) verwendet werden.

11. Verfahren nach Anspruch 10,
wobei zur Durchführung des Verfahrens ein Benutzeroberflächenmodul (BO) verwendet wird, welches als graphische Benutzeroberfläche ausgelegt ist und/oder Funktionalitäten zur Dateneingabe und/oder zur Datenverwaltung und/oder zur Datenausgabe aufweist und/oder zum Aufruf des Optimierungsmoduls und/oder zur Ergebnisdarstellung ausgelegt ist.

12. Verfahren nach einem der Ansprüche 9 bis 11,
wobei mindestens einer der Algorithmen des Optimierungsmoduls dazu ausgelegt wird, mit einer Zielfunktion eine Maximierung einer Anzahl der Solartrackern (ST) des Photovoltaik-Freiflächenkraftwerks (PV) zu erreichen.

13. Vorrichtung (VO) zum Erstellen eines Anlagenlayouts eines Photovoltaik-Freiflächenkraftwerks (PV), welches Kraftwerkskomponenten, insbesondere Solartracker (ST) aufweist, wobei die Vorrichtung (VO) ein Optimierungsmodul (OM) aufweist, welches dazu ausgelegt ist,
- das Photovoltaik-Freiflächenkraftwerk (PV) und Kraftwerkskomponenten spezifizierende Konfigurationsdaten, für das Photovoltaik-Freiflächenkraftwerk (PV) vorgegebene Konfigurationsregeln und die Konfigurationsregeln konkretisierende Konfigurationsparameter bereitzustellen; und
- eine Auswahl und eine Verortung von benötigten Kraftwerkskomponenten für Anlagenlayouteigenschaften des Photovoltaik-Freiflächenkraftwerks (PV) anhand der bereitgestellten Konfigurationsdaten und der konkretisierten Konfigurationsregeln zu initialisieren und anschließend zu optimieren, um das Anlagenlayout des Photovoltaik-Freiflächenkraftwerks (PV) zu erstellen.

14. Computerprogramm zur Durchführung des Verfahrens nach einem der Ansprüche 1-12.
